# EUROPEAN PATENT APPLICATION

(11) **EP 2 925 106 A1**
(43) Date of publication of application: **30.09.2015**
(21) Application number: 14460019.4
(22) Date of filing: 27.03.2014
(51) Int. Cl.: H05K 7/20, H02B 1/56

(54) **A standalone modular structure suitable for containing power electronic devices and other electric devices**

(71) Applicant: ABB Technology AG, 8050 Zürich (CH)
(72) Inventor: Rubinski, Darius, 90-560 Lodz (PL); Zacharowski, Cezary, 95-050 Konstantynow Lodzki (PL); Strzelecki, Michal, 95-100 Zgierz (PL); Paluba, Filip, 91-037 Lodz (PL)
(74) Representative: Chochorowska-Winiarska, Krystyna

(57) **Abstract**

The subject of the invention is a standalone modular structure suitable for containing power electronic devices and other electric devices, applicable in protecting power converter systems. A structure comprising a rectangular metal base-frame (1) shaping the external outline of the enclosure, on which at least one bottom frame (3) made of standard profiles is positioned. Each corner of the bottom frame (3) is connected with the vertical post (4) and all posts have their ends connected together by an upper frame (5) made of standard profiles. The standard profiles and vertical posts are forming a rear frame (9) of an enclosure cabinet (2) with window gaps for locating separate protection panels (14) or ventilation louver (28). Opposite the rear frame (9) a front frame (8) of the enclosure cabinet (2) is located having a window gap which is assigned for locating single or double doors (13). To the upper frame (5) a metal skeleton cooling box (6) is connected having a rear opening situated above the rear frame (9) and front opening situated above the front frame (8) and the box (6) is provided with a support frame (20) and a partition (22) for fixing inside the box (6) a cooling fan (24) and the box (6) is covered by roof (15) and has a bottom part partially made as a grid (27) which is a ventilating ceiling of the structure built from the bottom frame (3), vertical posts (4) and upper frame (5).

## Description

The subject of the invention is a standalone modular structure suitable for containing power electronic devices and other electric devices, for example transformers, applicable in protecting power converter systems, especially in protection synchronous compensator and battery energy storage systems (Statcom & BEES Systems) against adverse weather conditions and/or against accidental access by unauthorized persons or wild animals or birds.

Standalone structures in a form of an electrical outdoor enclosure for protecting electrical equipment are known very well in many applications. Standard constructions are made of welded steel profiles and need to be completely covered with sheet metal or sandwich panels to protect from outside conditions. The standalone outdoor enclosure that can be constructed to support the electrical equipment and be of a modular design to be assembled on location is known from patent application WO2014/005145. This modular enclosure includes a base and a frame coupled to the base. The base includes at least one mounting receptacle for mounting a fan. The enclosure can include four side panels coupled to the frame and back panel coupled to the frame in the interior of the enclosure. The back panel can be adapted to mount electrical equipment. A cover can be coupled to the frame and can include an overhang to prevent debris from entering the interior of the enclosure. The enclosure can also include a gravity controlled damper system with a damper that moves to an open position when internal pressure in the interior of the enclosure increases. The enclosure can include a passive air flow passage that ventilates the enclosure when the damper is in the closed position. In this solution the ventilation system with fans is placed in the base of the enclosure, what is very inconvenient in case of failure in such system, because all elements from the base should be removed. The side panels are coupled to the frame in such a way that any of this panel could be an inspection panel removable in easy method.

The essence of the present invention is that a standalone modular structure for containing power electronic devices and other electric devices comprising a rectangular metal base-frame shaping the external outline of the standalone structure, on which at least one bottom frame made of standard profiles is positioned. Each corner of the bottom frame is connected with the vertical post and all posts have their ends connected together by an upper frame made of standard profiles. Between two neighbouring vertical posts at least two cross-bars are placed. The standard profiles and vertical posts are forming a rear frame of an enclosure cabinet with window gaps for locating separate protection panels or ventilation louvers. Opposite the rear frame a front frame of the enclosure cabinet is located having a window gap which is assigned for locating single or double doors. To the upper frame a metal skeleton cooling box is connected having a rear opening situated above the rear frame and front opening situated above the front frame. The cooling box is provided with a support frame and a partition for fixing inside the box a cooling fan. The cooling box is covered by sloping roof and has a bottom part partially made as a grid which is a ventilating ceiling of the structure built from the bottom frame, vertical posts and upper frame.

Preferably perpendicular to the rear frame at least one of a side frames is provided having at least one cross-bar which is placed parallel to the standard profiles of the bottom and upper frame in the same plane as the side frame, forming window gaps for the protective panels or ventilation louvers.

Preferably the front frame is equipped with a removable vertical profile placed between the standard profile of the bottom frame and the standard profile of the upper frame.

Preferably the cross-bars and the removable vertical profile are made as Omega profiles.

Preferably all profiles are made as extruded anodized aluminum profiles.

Preferably the panels are made as sandwich panels or as bended sheet metal panels.

Preferably the sandwich panel is equipped with an intermediate layer made of insulation material.

Preferably the ventilation louver has rotary blade damper profiles.

Preferably the rotary blade damper profiles are actuated by servo -motor.

Preferably the support frame forms a channel arranged in such a way that there is a filter frame assembled on one side of the channel and a cover on the other side.

Preferably the grid has the width "w" at least three times smaller than the width "s" of the cooling box.

Preferably the cooling fan is radial fan which is placed above the grid of the cooling box.

Preferably the louver is placed in the rear frame above at least one panel.

Preferably at least one louver or/and panel is equipped with multiuse hinges in order to enable opening the inspection panels of the said frames downwards and upwards.

Preferably the vertical post is mounted to the bottom frame and to the upper frame by using only four screws and blind rivet nuts, respectively.

The most important advantages of the structure according to the invention is its modularity. The construction frames are made of extruded anodized aluminum profiles. There are several types of the profiles. Depending on client needs, the profiles can be insulated, which additionally protects power electronic from water condensation. In between profiles, panels are installed. The panels are also designed according to client needs. Each of the panels can be easily transformed into door or removable cover. By the usage of sandwich panels or steel sheet metal the overall thickness is decreased as the construction profiles are not covered. The skeleton of single base modular structure is completed with using the standard three corner joints so that no welding or strong bolt connections are needed.

In the structure according to the invention the panels can be converted into door or a removable panel at any time, what is not possible in standard constructions, where additional sub frames have to be assembled to the construction skeleton at the beginning and it is necessary to install door, removable panels. In the inventive structure bigger panels can be divided into smaller ones with "Omega" posts or cross bars, what additional reinforces the construction. If needed, "Omega" posts can be removable either. The structure according to the invention enables building smaller enclosures that can be assembled into bigger enclosures at the final stage of assembly on the base frame. This makes the assembling process easier as workers can be divided into smaller groups and work in parallel. In addition, very big constructions can be assembled from smaller ones, which makes warehousing and transportation easier. The assembly documentation for workers can also be simplified (no detailed technical drawings are necessary). Thanks to the new solution presented in the invention it is possible to achieve modularization, standardization, low weight, corrosion resistance (usage of aluminum) and easy adaptation to client's requirements.

The subject of the invention is presented as an embodiment in the drawing where:

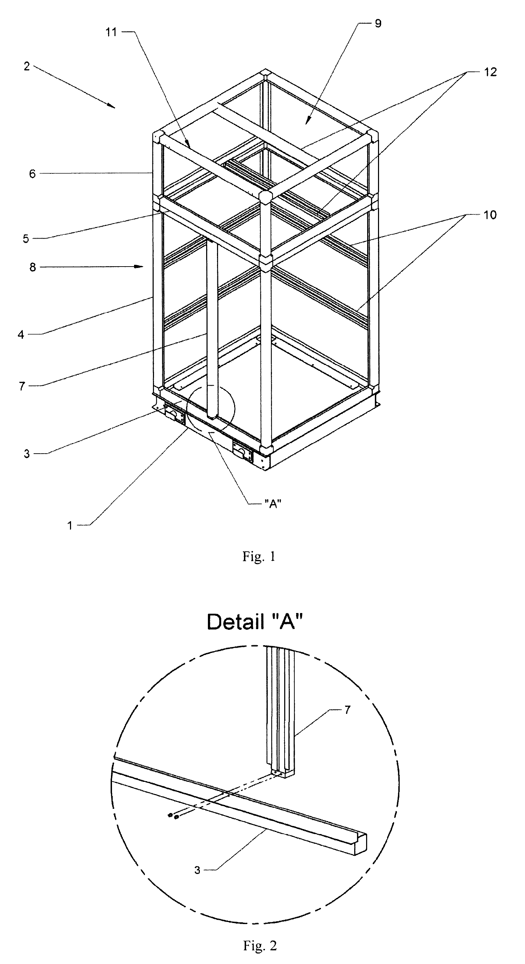

Fig.1 shows a skeleton of single base modular structure in a perspective view after demounting roof,
Fig.2 - a detail "a" from fig.1,
Fig.3 - a complete modular structure with two single base modular structures in a perspective view,

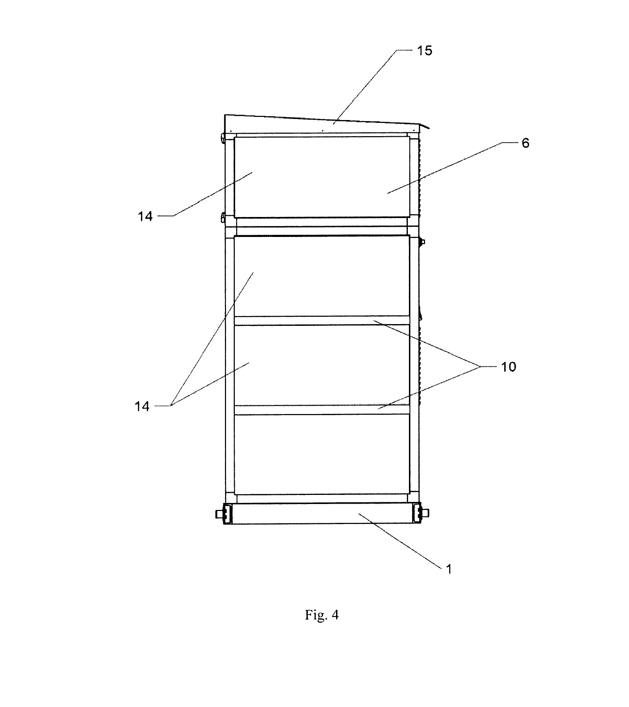

Fig.4 - a structure from fig.3 in a side view,
Fig.5 - a structure from fig.3 in a front view after demounting the doors and partial view for cooling box,

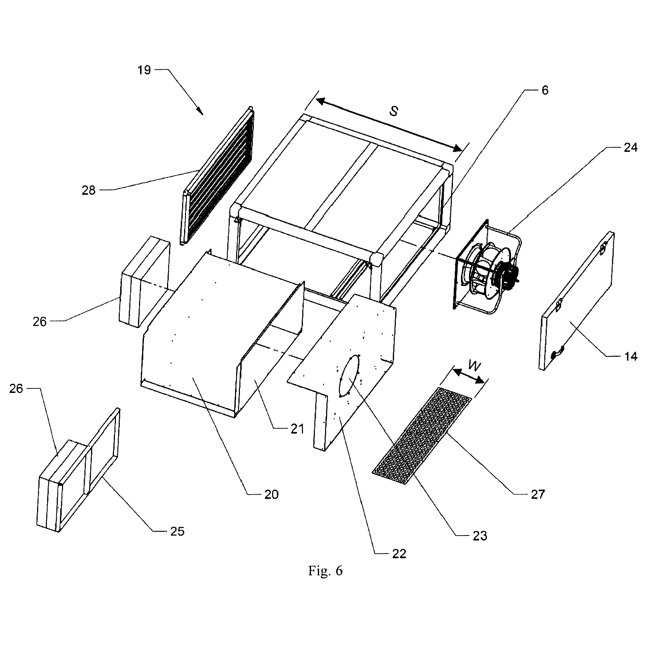

Fig.6 - a single cooling box of the structure from fig.3 in a perspective exploded view,

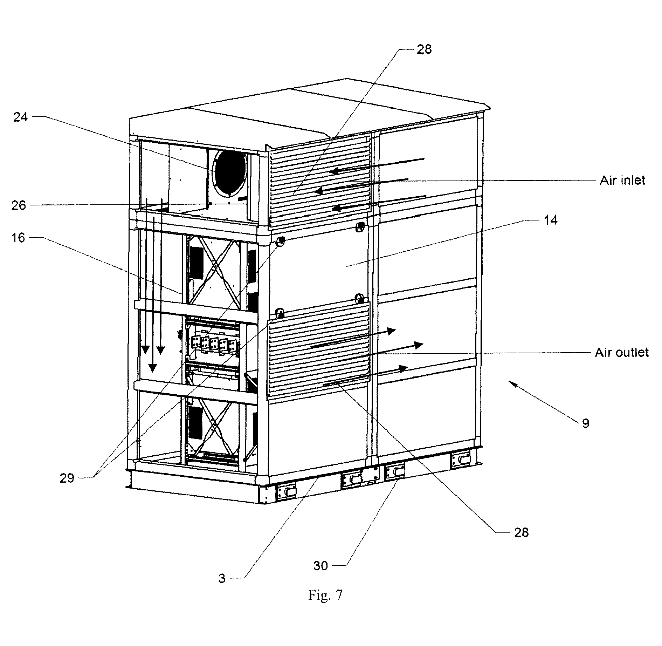

Fig.7 - a structure from fig.3 in a perspective view from the rear side after demounting side panels with arrows for indication the direction of airflow.

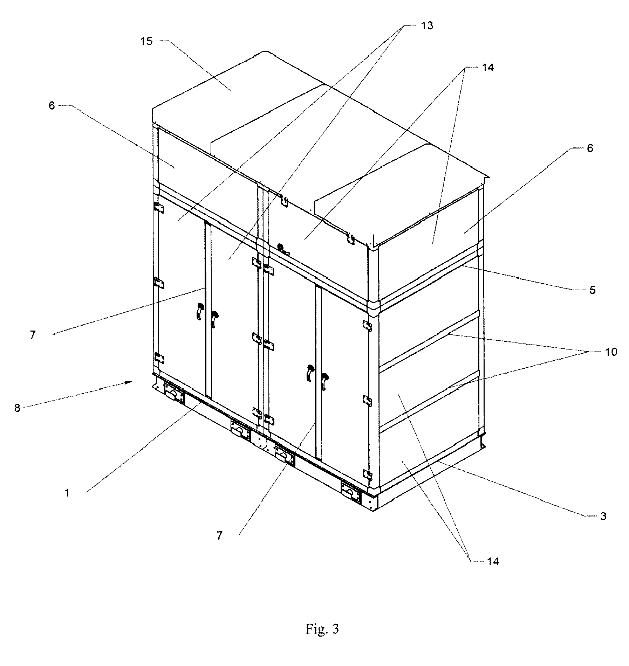

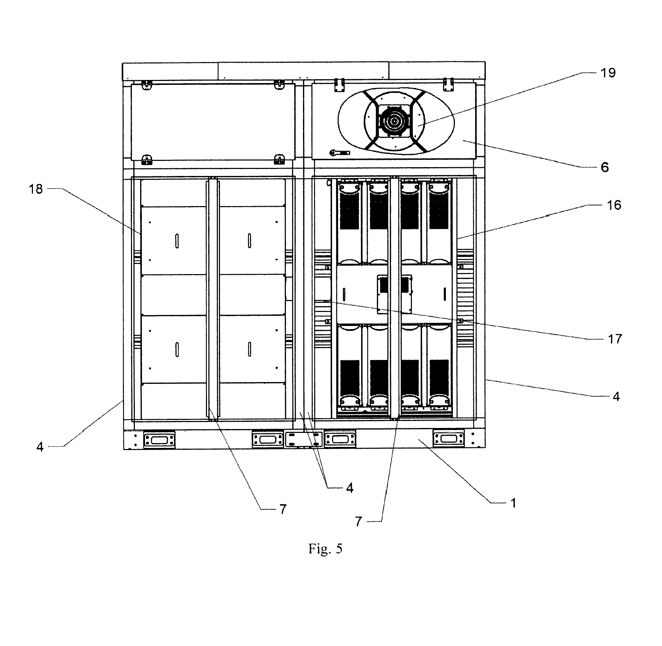

The modular structure for containing power electronic devices and other electric devices, e.g. transformers, comprises a metal base-frame 1 on which at least one enclosure cabinet 2 is mounted, where the cabinet has a modular structure having a rectangular bottom frame 3, made from standard profile, four vertical posts 4 made of standard profile, each placed in the corner of the bottom frame 2 and where all ends of the posts 4 are connected together with the upper frame 5, made from standard profile, situated parallel to the bottom frame 2. The base frame is further equipped with adhesive balloon gaskets placed at all edges of the standards profiles, what is not presented in the drawings. The purpose of using the special design gaskets is to limit the silicon material for sealing the joined elements of the frame. The upper frame 5 is connected with the cooling box 6 having also a skeleton structure with openings from each side, and the skeleton is made of standard profile. All parts of the standard profiles of the enclosure cabinet are connected together by standard connection elements, such as cast aluminum three corner joints, not indicated in the drawing. Between the bottom frame and the upper frame of the cabinet a removable vertical profile 7 is inserted forming a front frame 8 of the cabinet. The removable vertical profile is made of "Omega" profile. Opposite the front frame of the cabinet a rear frame 9 of the cabinet is situated and is equipped with at least two crossbars 10 forming window gaps in the rear frame 9. Perpendicular to the rear frame 10 at least one side frame 11 is situated which is equipped with the crossbars 10. At least two of the crossbar 10 are also inserted to the side frame 11. The crossbars 11 are made of "Omega" profile. The skeleton of the cooling box 6 is equipped with two support bars 12, one is placed on the bottom of the box perpendicular to the removable vertical profile 7 and the other is place on the top of the box 6, parallel to the first support bar. On the frame 1 presented in fig.3 two skeleton cabinets 2 are mounted together forming a complete modular structure. Each of the front frames 8 is equipped with door/doors 13 situated in the window gaps of the frames 8 between the vertical post 4 and removable vertical post 7. The vertical post 7 is made of "Omega" profile and is mounted to the bottom frame 3 by using only two screws, indicated in the drawings as dot lines, and blind rivet nuts, indicated in the drawing as a black dots. The post 7 is mounted in the same way to the upper frame 5, what is not presented in the drawing. The doors 13 may be opened in two different directions thus making the structure more solid. The rear frame 9 and the side frame 11, having the crossbars 10 are equipped with the panels 14 that fill the window gaps in the mentioned frames. The panels 14 are made as sandwich panel or as bended sheet metal panels. Similar panel is inserted into the skeleton of the cooling box 6 to its front and side frame situated above the front frame 8 and side frame 11 relatively. All panels 14 can be made of aluminum sheets and inside the panels polyurethane foam or mineral wool can be inserted. The panels may be used as protection panels, which are fixed to the enclosure cabinet frames or as inspection panels, which can be opened downward or upward, or which are mounted to these frames in a removable way. In order to seal panels in the window gaps of the frames the balloon gaskets are used at all outside profile flanges of the frames. On the cooling boxes 6 a sloping roof 15 is mounted for directing water stream in such manner that it flows on the ground with no contact with any parts of the complete structure. The roof 15 is equipped with additional supports, not presented in the drawing, to prevent it from deformation under the load of snow/ice. In fig.5 a complete structure is presented without the doors from the front view. Inside the structure an exemplary electronic device 16 namely as PCT 100 Rack with eight modules are situated together with busbars 17 and a control cabinet 18. In the cooling box a cooling system 19 is inserted. The cooling system comprises a support frame 20 forming a channel 21 which is closed from one side by a partition 22 having an orifice 23 for assembling to it a radial fan 24. The channel 21 is closed from the other side by a filter frame 25 where filters 26 are inserted. When the cooling system is inserted into the cooling box 6 between the partition 22 and the front profiles at the bottom of the cooling box a grid 27 is located. The grid 27 has a width "w" at least three times smaller than a width "s" of the cooling box 6, yet always wide enough to enable proper air circulation. The grid 27 forms a ceiling of the structure built from the bottom frame 2, vertical post 3 and upper frame 4. The radial fan 24 is placed above the grid 27. The rear frame of the cooling box 6 is closed by the louver 28. Similar louver 28 is placed in the window of the rear frame 9. This louver must be placed at appropriate height from the bottom frame 3 which is determined by the location of air extraction fans inbuilt in the electronic equipment housed in the cabinet 2. In the exemplary embodiment of the invention, the electronic device 16 having a form of the PCT 100 Rack with eight modules is equipped with its own inbuilt fans, what is not presented in the drawings. On the fan air flow level, in the rear frame 9 of the enclosure cabinet 2, the louver 28 is placed and it is situated above the panel 14. All the louvers may be constructed as having solid or movable blade damper profiles. In case where the blade dampers are movable a special servo-motor is used for actuating their motion, what is not presented in the drawing. The panels 14 and the louvers 28 may be equipped with multiuse hinges 29. When at least two multiuse hinges are placed on the bottom of the frame the panel can be opened downwards. When at least two multiuse hinges are placed on the top of the frame the panel can be opened upwards. When at least two multiuse hinges are placed on the bottom and on the top of the frame the panel can be easily removed from the frame. All multiuse hinges 29 are equipped with key locks, what is not presented in the drawings, that are opened with the same key. In the structure according to the invention except the multiuse hinges 29 for door/doors a standard door hinge and standard door handle/handles and locks are used, however, every lock, regardless of being handle or multiuse hinge lock, is opened by the very same key. Additionally the base frame 1 is equipped with attachment fitting 30 for overhead crane belts for transportation purposes, which are placed on the front and back external vertical surfaces of the base frame.

### List of indications

1. metal base-frame
2. enclosure cabinet
3. bottom frame
4. vertical post
5. upper frame
6. cooling box
7. removable vertical profile
8. front frame
9. rear frame
10. cross bar
11. side frame
12. support bar
13. door
14. protection panel
15. roof
16. electronic device
17. busbars
18. control cabinet
19. cooling system
20. support frame
21. channel
22. partition
23. orifice
24. cooling fan
25. filter frame
26. filter
27. grid
28. ventilation louver
29. multiuse hinge
30. attachment fitting

## Claims

1. A standalone modular structure for containing power electronic devices and other electric devices comprising a rectangular metal base-frame (1) shaping the external outline of the standalone structure, on which at least one bottom frame (3) made of standard profiles is positioned; each corner of the bottom frame (3) is connected with the vertical post (4) and all posts have their ends connected together by an upper frame (5) made of standard profiles; between two neighbouring vertical posts (4) at least two cross-bars (10) are placed parallel to the standard profiles of the bottom (2) and upper frame (5) situated in the same plane and these cross-bars; standard profiles and vertical posts are forming a rear frame (9) of an enclosure cabinet (2) with window gaps for locating separate protection panels (14) or ventilation louvers (28); and opposite the rear frame (9) a front frame (8) of the enclosure cabinet (2) is located having a window gap which is assigned for locating single or double doors (13), **characterized in that** to the upper frame (5) a metal skeleton cooling box (6) is connected having a rear opening situated above the rear frame (9) and front opening situated above the front frame (8) and the box (6) is provided with a support frame (20) and a partition (22) for fixing inside the box (6) a cooling fan (24) and the box (6) is covered by roof (15) and has a bottom part partially made as a grid (27) which is a ventilating ceiling of the structure built from the bottom frame (3), vertical posts (4) and upper frame (5).

2. The structure according to claim 1, **characterized in that** perpendicular to the rear frame (9) at least one of a side frames (11) is provided having at least one cross-bar (10) which is placed parallel to the standard profiles of the bottom (3) and upper frame (5) in the same plane as the side frame (11), forming window gaps for the protective panels (14) or ventilation louvers (28).

3. The structure according to claim 1, **characterized in that** the front frame (8) is equipped with a removable vertical profile (7) placed between the standard profile of the bottom frame (3) and the standard profile of the upper frame (5).

4. The structure according to claim 1-3, **characterized in that** the cross-bars (10) and the removable vertical profile (7) are made as Omega profiles.

5. The structure according to claim 1-4 **characterized in that** all profiles are made as extruded anodized aluminum profiles.

6. The structure according to claim 1-5 **characterized in that** the panels (14) are made as sandwich panels or as bended sheet metal panels.

7. The structure according to claim 6, **characterized in that** the sandwich panel is equipped with an intermediate layer made of insulation material.

8. The structure according to claim 1-5, **characterized in that** the ventilation louver (28) has rotary blade damper profiles.

9. The structure according to claim 8, **characterized in that** the rotary blade damper profiles are actuated by servo -motor.

10. The structure according to claim 1, **characterized in that** the support frame (20) forms a channel (21) arranged in such a way that there is a filter frame (25) assembled on one side of the channel and the partition (22) on the other side.

11. The structure according to any previous claims, **characterized in that** the grid (27) has the width (w) at least three times smaller than the width (s) of the cooling box (6).

12. The structure according to any previous claims, **characterized in that** the cooling fan (24) is a radial fan and is placed above the grid (27) of the cooling box (6).

13. The structure according to any previous claims, **characterized in that** the louver (28) is placed in the rear frame (9) above at least one panel (14).

14. The structure according to any previous claims, **characterized in that** at least one louver (28) or/and panel (14) is equipped with multiuse hinges (28) in order to enable opening the inspection panels of the rear frame (9) or the side frame (11) downwards and upwards.

15. The structure according to any previous claims, **characterized in that** the vertical post (7) is mounted to the bottom frame (3) and to the upper frame (5) by using only four screws and blind rivet nuts, respectively.
